# EUROPEAN PATENT APPLICATION

(11) **EP 1 871 155 A1**
(43) Date of publication of application: **26.12.2007**
(21) Application number: 06291046.8
(22) Date of filing: 21.06.2006
(51) Int. Cl.: H05K 7/20

(54) **Cooled shelf for printed circuit boards**

(71) Applicant: Alcatel Lucent, 75008 Paris (FR)
(72) Inventor: Speciale, Massimo, 16163 Genova (IT); Perasso, Aldo, 16145 Genova (IT); Cassinelli, Claudio, 16156 Genova (IT)
(74) Representative: Menzietti, Domenico

(57) **Abstract**

The present invention relates to a shelf (100) for holding printed circuit boards; the shelf (100) comprises a first frame (1) and a second frame (2), adapted to hold printed circuit boards, and a panel (3) provided with two opposite sides (31, 32), wherein the first frame (1) is mounted on a first (31) of the two sides (31, 32) and the second frame (2) is mounted on a second (32) of the two sides (31, 32); the shelf (100) comprises further cooling means (4) adapted to generate an airflow for cooling the printed circuit boards held by the first frame (1) and deflecting means (5) adapted to deflect at least part of said airflow for cooling the printed circuit boards held by the second frame (2).

## Description

The present invention relates to a cooled shelf for holding printed circuit boards according to the preamble of claim 1, as well as to a related cooled cabinet and cooling method.

Shelves for holding printed circuit boards typically comprise one or more metal frames adapted to hold printed circuit boards. The frames could be disposed one on top of the other, side by side or one at the back of the other.

When a plurality of boards are to be held by a frame, it is advantageous to dispose them in parallel and typically in a vertical position, in order to save space within the frame and in order to fit the highest number of boards within the same frame. The gap between each board is then much reduced, therefore the circulation of air within the shelf is also much reduced. The very limited circulation of air causes a relevant increase of temperature between the boards and consequently in the shelf. The rise in temperature is caused by the fact that printed circuit boards are typically provided with passive modules (e.g. resistors, capacitors, inductances) and with active modules (e.g. transistors, integrated circuits such as processors); especially the active ones do generate a lot of heat during their functioning.

The rise of temperature within the shelf may cause for example malfunctioning of the modules (and of the boards and of whole electronic apparatus), therefore, in order to keep the rise of temperature under control, it is common to use cabinets (containing one or more shelves) with slits typically on their sides provided for letting air circulate within the shelf or shelves of the cabinet.

Moreover, besides the slits, the temperature within the shelf is kept from rising through one or more fans duly dimensioned in size and in speed of rotation. Typically said fans are fitted in proximity of active modules (e.g. processors) so that fresh air is blown substantially onto such modules to keep it under a certain temperature; it is also known to fit at least a fan in proximity of the slits so that the warm air generated inside the shelf or shelves is sucked out from the cabinet.

The present invention arises from the reflections made by the Applicant concerning those cases in which, for instance, the shelf for holding printed circuit boards comprises frames disposed one at the back of the other so to have a front access frame and a rear access frame.

Nowadays, it is known to provide the rear access frame with printed circuit boards comprising passive modules as they are less subject to failures or breakages which imply substitution of the damaged module and/or the corresponding board by personnel.

The present invention may advantageously be applied to all those cases where there is a need of having on the rear access frames printed circuit boards comprising not only passive modules but also active modules.

Therefore, to provide active modules also on the printed circuit boards held by the rear access frame, the increase of temperature has to be kept under control and moreover the temperature has to be kept under a certain level.

A way of keeping under control the temperature over the printed circuit boards could be to place one or more fans not only in the front side of the shelf but also in the rear side of the shelf.

Nevertheless, the above described solution turns out to have particular drawbacks such as waste of available space within the shelf for possible additional printed circuits boards and/or for possible additional modules.

Another drawback of the above mentioned solution lies in the fact that the additional fans provided for reducing the temperature over the printed circuit boards involve an increase in power consumption with an inevitable increase in cost.

A further drawback of the above mentioned solution lies in the fact that increased number of mechanical devices, such as fans, may cause a decrease in reliability as more devices could be subject to failures or breakages.

The general object of the present invention is to provide a solution being innovative compared to the state of the art, as far as cooling the printed circuit boards held by shelves and ease of maintenance service are concerned.

In particular, a specific object of the present invention is to provide a cooling solution for shelves holding printed circuit boards and comprising at least a first (front) access frame and a second (rear) access frame which allows to reduce manufacturing costs and hence sale prices.

Another specific object of the present invention is to provide lower power consumption as well as to provide the same thermal performances of the prior art.

A further specific object of the present invention is to provide an extreme degree of integration in smaller shelves, as well as to provide high reliability.

These objects are substantially achieved by the shelf having the features set out in the annexed independent claim 1; advantageous aspects of the present invention are set out in the annexed dependent claims.

The basic idea of the present invention is to let that the same air cools the printed circuit boards in one zone or side as well as the printed circuit boards in another zone or side, typically the opposite side. In particular, a cooling airflow is generated in the front side of a shelf and is deflected at least partially to the rear side of the same shelf.

There are also parts of the present invention a cooled cabinet and a cooling method related to this cooled shelf having the features set out in the annexed claims.

Further objects, features and advantages of the present invention will become apparent from the following detailed description and the annexed drawings wherein:
Fig. 1 shows a schematic view of a shelf for holding printed circuit boards according to a preferred embodiment of the present invention;
Fig. 2 shows a schematic representation of the airflows within the shelf of Fig.1; and
Fig. 3 shows a schematic representation of the airflow within a cabinet according to a preferred embodiment of the present invention.

Said description and said drawings are to be considered as non-limiting examples.

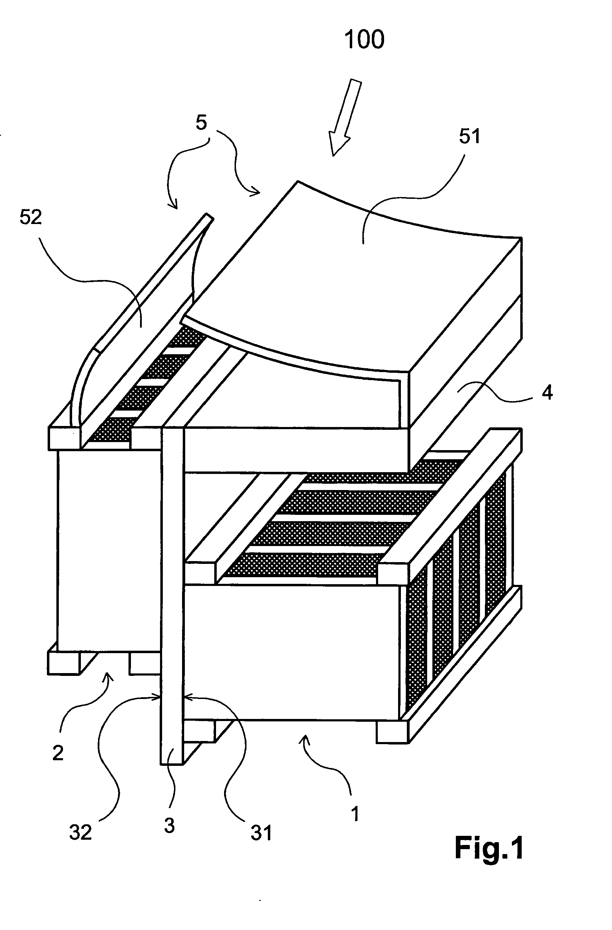

Getting into detail of the drawings, Fig. 1 shows a schematic and simplified view of a shelf for holding printed circuit boards, indicated as a whole with the reference number 100. According to the present invention, shelf 100 comprises a front access frame 1 and a rear access frame 2 (typically made of metal). In the following description front access frame 1 will be referred to as "first frame", while rear access frame 2 will be referred to as "second frame".

According to the present invention said first frame 1 and second frame 2 are mounted on a panel 3. Said panel 3, provides two opposite sides: a first side 31 and a second side 32. As shown in the embodiment of Fig.1, first frame 1 is mounted on first side 31 of panel 3, and second frame 2 is mounted on second side 32 of panel 3.

In the embodiment of the figures, panel 3 is a single large multi-layer (e.g. 20-40 layers) printed circuit board and therefore it is quite thick, e.g. 5-10 mm and is used to electrically connect the printed circuit boards held by first frame 1 and the printed circuit boards held by second frame 2. Alternatively, for example, such panel may comprise two thinner printed circuit boards fixed together or to opposite sides of a supporting frame.

Both first frame 1 and second frame 2 hold printed circuit boards comprising active and passive modules (not shown in Fig.1) which are advantageously vertically disposed in parallel and rather close the one to the other.

Moreover, Fig. 1 shows cooling means 4 which are placed over first frame 1 at a certain distance, e.g. 8 ÷ 12 cm, (for flow uniformity reasons) and mounted on panel 3, in particular on first side 31. According to the present invention, said cooling means 4 is a fan assembly comprising one or more fans (not visible in Fig. 1). The axes of rotation of said fans are vertical and parallel to the printed circuit boards held by first frame 1. Said fans are adapted to establish an airflow within the first frame 1; according to the preferred embodiment said fans have a speed of rotation in the range of about 1500 ÷ 6000 rpm.

Shelf 100 of Fig.1 comprises, on its top side, two deflecting means which, in the following description, will be globally referred to with reference number 5. Getting into more detail, according to the present embodiment, first deflecting means (i.e. a first deflector) 51 is provided over cooling means 4, and therefore over first frame 1, second deflecting means (i.e. a second deflector) 52 is provided over second frame 2. Deflector means 5, according to the embodiment shown in the figures, are typically made of metal.

According to the present embodiment, deflector means 51 and deflector means 52 can be fixed on one side to first frame 1 and to second frame 2, respectively. In Fig.1 deflector means 51 has a substantially a rectangular shape slightly curved upwards, while the deflector 52 has substantially a rectangular shape slightly curved downwards.

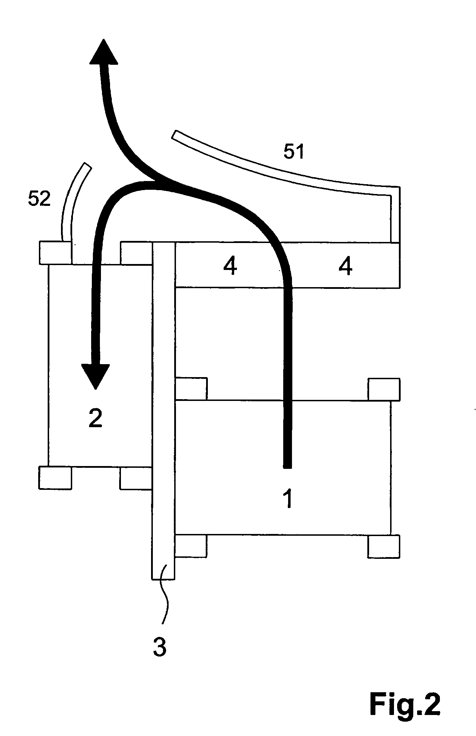

Fig.2 shows a schematic representation of the path followed by the airflows within the shelf of Fig.1.

According to the present invention, an airflow is generated by means of the fans of assembly 4, it enters first frame 1, then it passes through the printed circuit boards held by first frame 1, and it exits from the first frame 1. Only part of the airflow which has exited from first frame 1 enters second frame 2, after having been appropriately deflected to get (partially or totally) through the printed circuit boards held by second frame 2.

In the embodiment of the figures, the shelf is relatively small and is about 40 cm high, about 45 cm wide, about 45 cm deep; in this case, it may be sufficient that the airflow entering the second frame moves downwards for about 25 ÷ 30 cm and not necessarily for the whole height of the shelf (i.e. 40 cm). Typical embodiments of the present invention are from 30 cm to 50 cm high, from 35 cm to 90 cm wide, from 35 cm to 65 cm deep.

In general, the shelf for holding printed circuit boards according to the present invention comprises first and second frames, adapted to hold printed circuit boards; moreover, it comprises cooling means adapted to generate airflow for cooling the printed circuit boards held by the first frame. The shelf of the present invention comprises also deflecting means adapted to deflect at least part of said airflow for cooling the printed circuit boards held by the second frame.

More in detail, the shelf according to the present invention comprises advantageously a first frame and a second frame adapted to hold printed circuit boards respectively. It comprises also a panel which provides two opposite sides: a first side and a second side. Said first and second frame are mounted on the first of the two sides and on the second of the two sides respectively.

According to the embodiment shown in the figures, the panel is advantageously adapted to connect one or more of the printed circuit boards held by the first and the second frames.

The shelf of the present invention also comprises cooling means, in particular at least one fan, which, in a preferred embodiment of the present invention, is advantageously located substantially over said first frame. Alternatively, the location of the cooling means could be substantially under the first frame being the layout of the shelf such to provide sufficient space under the printed circuit boards.

According to another possible embodiment, the cooling means could be located on the right or on the left of the first frame; in this case, the printed circuit boards should be disposed in parallel in a substantial horizontal position.

Nevertheless, as it is preferable to dispose the printed circuit boards in parallel in a substantially vertical position, according to the best embodiment of the present invention, the location of said cooling means over the first frame is advantageous, compared to the alternative locations, as a broader surface is covered by the airflow generated by said cooling means and as the layout of the shelf (shown in Fig.1) is such to provide suitable space for the cooling means.

According to the present invention the shelf also comprises deflecting means adapted to deflect at least part of the airflow generated by the cooling means for cooling the printed circuit boards held by the second frame.

Advantageously, the deflecting means comprises first deflecting means and second deflecting means, e.g. deflectors, wherein in particular said first deflector is located substantially over the first frame, and the second deflector is located substantially over the second frame.

The location of the first and second deflecting means could also be changed in other possible embodiments of the present invention; in fact, the first deflector can be located under the first frame being the second deflector located under the second frame, and being preferably the printed circuit boards disposed in parallel in a substantially vertical position.

Moreover, according to other possible embodiments which do not depart from the inventive idea of the present invention, the location of the first deflector could be on the right or on the left of the first frame, being the second deflector located respectively on the right or on the left of the second frame and being the printed circuit boards aligned face to face in a substantially horizontal position.

It is worth noting that, wherever the cooling means and the deflecting means are located, corresponding space within the shelf is to be provided for them.

According to the present invention, one or more of the printed circuit boards held by the first and the second frame, comprise active modules. It is common to provide printed circuit boards also with passive modules. Typically, during their functioning both active and passive modules do generate heat which causes an increase of the temperature within the housing, e.g. cabinet, of the shelf.

According to the preferred embodiment of the figures, the cooling means, in particular at least one fan, is located between the first frame and the first deflector.

Said cooling means are adapted to generate an airflow which enters the first frame on one side and exits from the same first frame on the opposite side, and which enters at least in part the second frame on one side corresponding to the opposite side of the first frame.

In particular, according to the preferred embodiment of the figures, the airflow generated by the cooling means enters the first frame on its bottom side and exits from said first frame on its top side. As shown in Fig.1 and more in detail in Fig.2, the second deflector is configured in such a way to intercept a part of the flow which exits from frame 1; the rectangular shape of the second deflector is advantageously curved downwards to deflect the part of the intercepted airflow in order to let it enter the second frame from its top side.

The method according to the present invention is useful for cooling printed circuit boards contained within a housing, such as a shelf or a cabinet, comprising at least a first zone and a second zone (preferably clearly separated between each other); printed circuit boards are located both in the first and second zones.

The method according to the invention provides for the generation of airflow for cooling the printed circuit boards located in the first zone and the subsequent deflection of at least part of this airflow into the second zone.

According to the embodiment of the figures, the velocity of the airflow established within the shelf is typically in the range of 2 - 6 m/s.

In general, according to the method of the present invention, the airflow is generated through cooling means; advantageously, such cooling means are one or more fans placed over the first zone. The fans are typically activated in order to control the temperature within the housing; an increase of temperature, due to the functioning of the active and passive modules, comprised in the printed circuit boards, may causes failures or breakages of the modules.

According to the present method, the airflow generated by the cooling means, advantageously enters said first zone on one side, in particular from the bottom, and exits from said first zone on the opposite side, in particular from the top side.

The airflow, according to the present method, passes through the first zone, in particular through the printed circuit boards in order to cool the modules therein comprised. Said step is facilitated by the fact that passing through the printed circuit boards the air is heated and therefore, for a well known physical law, it raises spontaneously.

Thereafter, it is useful and advantageous to divide the method, according to the present invention, in two successive steps.

The cooling method according to the present invention provides a first step in which the airflow established within the first zone and exited from said first zone is entirely deflected, in particular it is deflected towards the second zone.

The cooling method according to the present invention provides a second step in which at least a part of said airflow is intercepted and deflected into the second zone. Advantageously, only a part of the airflow exited from the first zone is deflected into the second zone; in fact, it is important is to avoid that air returns into the first zone (due to the deflecting means) in order not to cause loss in cooling efficiency.

According to the cooling method applied in the embodiment of Fig. 1 and Fig.2, the part of airflow which is intercepted enters the second zone on one side corresponding to the side of the first zone where the airflow exits from; in other words, the intercepted airflow is diverted back into the second zone in particular on the top side of the housing.

In the embodiment of Fig.1 and Fig.2, the two zones belong to the same equipment, namely shelf 100, and correspond rispectively to the zone identified by its first frame 1 and its second frame 2.

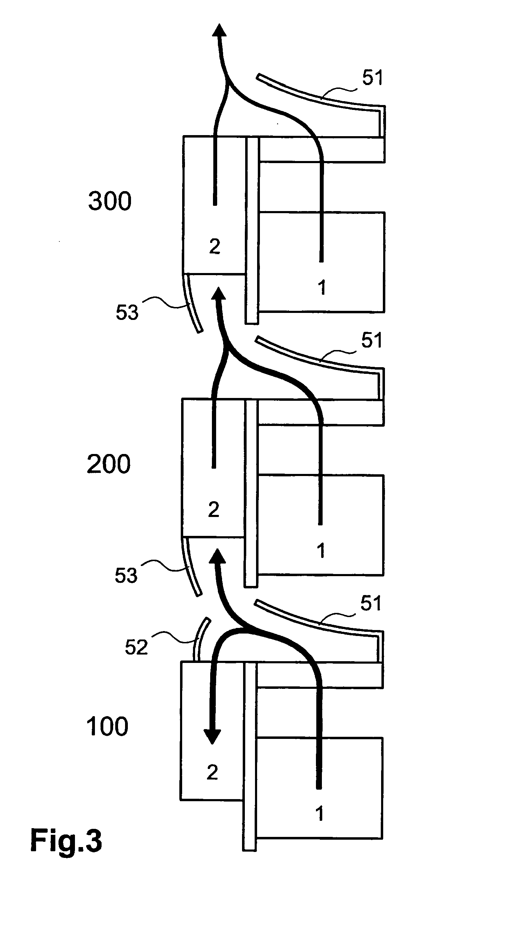

A further and independent teaching of the present invention is to successively cool zones of different housings (e.g. two shelves or two cabinets) by means of appropriate deflections of airflows. This is the case of the embodiment of Fig.3.

In Fig.3, three shelves 100, 200, 300 are located one over the other within the same cabinet (not shown). Shelf 100 corresponds to the shelf of Fig.1 and Fig.2. Shelf 200 is located over shelf 100 and is similar to shelf 100; anyway, it has no deflecting means 52 but deflecting means 53. Shelf 300 is located over shelf 200 and is identical to shelf 200. It is to be noted that shelf 300, i.e. the top shelf, could be provided alternatively only with deflecting means 53 and without deflecting means 51 and 52.

Additional deflecting means 53 of each of shelves 200 and 300 is adapted to deflect an additional airflow entering the shelf and exiting from another shelf for cooling the printed circuit boards held by its second frame 2.

Deflecting means 53 of a shelf, e.g. 200, are configured so that this additional airflow comes from a zone substantially aligned to its first frame 1, in particular the zone identified by first frame 1 of equipment 100 below, and enters a zone identified by second frame 2 of equipment 200. This additional airflow enters second frame 2 on one side, in particular on its bottom side, and exits from second frame 2 on the opposite side, in particular its top side.

In the embodiment of Fig.3, the airflow exiting from second frame 2 of shelves 200 and 300 joins rispectively with the airflow exiting from first frame 1 of shelves 200 and 300 and deflected by deflecting means 51. Alternatively, the airflow exiting from second frame 2 of shelf 200 may at least partially exits from the cabinet through appropriate slits.

In the embodiment of Fig.3, only in the bottom shelf, namely shelf 100, some air is internally circulated, i.e. used for cooling the printed circuit boards of both the boards of the first and second frames, and in the other upper shelves, namely shelves 200 and 300, airflows pass through first frame 1 of one shelf and then through second frame 2 of the shelf above.

Advantageously, additional deflecting means 53 is located substantially over, under (most typically and advantageously), on the right of or on the left of second frame 2.

A shelf having any combination of the above described deflecting means falls within the inventive idea of the present invention.

As already stated, an aspect of the present invention corresponds to a cabinet in particular for electronic apparatuses.

In the cabinet according to the present invention, one or more shelves according to the present invention may be housed. These shelves may be identical, similar or different; in the embodiment of Fig.3, shelves 200 and 300 are identical and shelf 100 is different (with means 52 and without means 53) but similar to these; alternatively and as already said, shelf 300 might have been different (without means 51) but similar to shelf 200.

In the cabinet according to the present invention, the cooling method according to the present invention is used.

It is to be noted that in the same cabinet different embodiments of the present method can advantageously be used in distinct parts of the cabinet, as in the embodiment of Fig.3.

With regard to shelf 100, the airflow used for cooling the boards of its first frame is partially deflected for cooling the boards of its second frames.

With regard to the combination of shelves 100 and 200, the airflow used for cooling the boards of the first frame of shelf 100 is partially deflected for cooling the boards of the second frames of shelf 200 (and, less directly, the boards of the second frames of shelf 300).

With regard to the combination of shelves 200 and 300, the airflow used for cooling the boards of the first frame of shelf 200 is totally deflected for cooling the boards of the second frames of shelf 300.

The drawings schematically show deflecting means 51, 52, 53 mounted on the shelves. Alternatively, the deflecting means can be mounted on the cabinet; according to this last embodiment, the cabinet comprises at least one shelf. The shelf comprises a first frame and a second frame adapted to hold printed circuit boards, a panel provided with two opposite sides, wherein the first frame is mounted on a first of the two sides and the second frame is mounted on a second of the two sides, and cooling means adapted to generate an airflow for cooling the printed circuit boards held by the first frame. The cabinet further comprises at least one deflecting means adapted to deflect at least part of the airflow for cooling the printed circuit boards held by the second frame.

The cabinet can further comprise another shelf. This other shelf comprises a first frame and a second frame adapted to hold printed circuit boards, a panel provided with two opposite sides, wherein the first frame is mounted on a first of the two sides and the second frame is mounted on a second of the two sides. The deflecting means are further adapted to deflect at least another part of the airflow for cooling the printed circuit boards held by the second frame of the other shelf.

From the above description it is clear that the present invention has several advantages.

In fact, it is possible to cool printed circuit boards located and held by a rear access frame through the same cooling means provided for cooling the printed circuit boards located and held by a front access frame; such idea is very reliable, simple and economical.

Moreover providing a shelf with deflecting means, reduces the number of specific maintenance services due to possible faults of mechanical parts in a non easy access area of the shelf.

Another advantage of the present invention is to provide a cooling method capable of cooling cabinets comprising one or more shelves according to the present invention.

It is clear that many other changes are possible for those skilled in the art to the technical solution previously described without departing from the inventive idea resulting from the annexed claims and from the description of the preferred embodiments.

## Claims

1. Shelf (100) for holding printed circuit boards, the shelf comprising:
- a first frame (1) and a second frame (2) adapted to hold printed circuit boards;
- a panel (3) provided with two opposite sides (31, 32), wherein the first frame (1) is mounted on a first (31) of the two sides (31, 32) and the second frame (2) is mounted on a second (32) of the two sides (31, 32);
- cooling means (4) adapted to generate an airflow for cooling the printed circuit boards held by the first frame (1);
**characterized in that** it comprises deflecting means (5) adapted to deflect at least part of said airflow for cooling the printed circuit boards held by the second frame (2).

2. Shelf (100) according to claim 1, **characterized by** being configured so that said airflow enters said first frame (1) on one side and exits from said first frame (1) on the opposite side and so that at least part of said airflow exiting from said first frame (1) enters said second frame (2) on one side corresponding to the opposite side of said first frame (1).

3. Shelf (100) according to claim 2, **characterized by** being configured so that said airflow enters said first frame (1) on its bottom side and exits from said first frame (1) on its top side and so that at least part of said airflow exiting from said first frame (1) enters said second frame (2) on its top side.

4. Shelf (100) according to any of the preceding claims, wherein said deflecting means (5) comprises first deflecting means (51) and second deflecting means (52).

5. Shelf (100) according to claim 4, wherein said first deflecting means (51) is located substantially over, under, on the right of or on the left of said first frame (1) and wherein said second deflecting means (52) is located respectively substantially over, under, on the right of or on the left of said second frame (2).

6. Shelf (100) according to claim 5, **characterized by** comprising at least one fan located respectively substantially over, under, on the right of or on the left of said first frame (1).

7. Shelf (100) according to claim 6, wherein said at least one fan is located between said first frame (1) and said first deflecting means (51).

8. Shelf (100) according to claim 4 or 5 or 6 or 7, wherein said second deflecting means (52) is adapted to intercept and deflect at least part of the airflow deflected by said first deflecting means (51).

9. Shelf (100) according to any of the preceding claims, wherein one or more of said printed circuit boards held by said first frame (1) comprise active modules and wherein one or more of said printed circuit boards held by said second frame (2) comprise active modules.

10. Shelf (100) according to any of the preceding claims, wherein said panel (3) is adapted to electrically connect one or more of said printed circuit boards held by said first frame (1) and one or more of said printed circuit boards held by said second frame (2).

11. Shelf (200, 300) in particular according to any of the preceding claims, **characterized in that** it comprises deflecting means (5) adapted to deflect another airflow entering said shelf and exiting from another shelf for cooling the printed circuit boards held by the second frame (2).

12. Shelf (200, 300) according to claim 11, wherein said deflecting means (5) comprises third deflecting means (53) being configured so that said other airflow comes from a zone substantially aligned to said first frame (1) and enters said second frame (2).

13. Shelf (200, 300) according to claim 11 or 12, wherein said other airflow enters said second frame (2) on one side, in particular on its bottom side, and exits from said second frame (2) on the opposite side, in particular its top side.

14. Shelf (200, 300) according to claim 11 or 12 or 13, wherein said third deflecting means (53) is located substantially over, under, on the right of or on the left of said second frame (2).

15. Cabinet comprising at least one shelf (100) for holding printed circuit boards, the shelf comprising:
- a first frame (1) and a second frame (2) adapted to hold printed circuit boards;
- a panel (3) provided with two opposite sides (31, 32), wherein the first frame (1) is mounted on a first (31) of the two sides (31, 32) and the second frame (2) is mounted on a second (32) of the two sides (31, 32);
- cooling means (4) adapted to generate an airflow for cooling the printed circuit boards held by the first frame (1);
**characterized in that** the cabinet comprises at least one deflecting means (5) adapted to deflect at least part of said airflow for cooling the printed circuit boards held by the second frame (2).

16. Cabinet according to claim 15, the cabinet further including another shelf (200), the other shelf comprising:
- a first frame (1) and a second frame (2) adapted to hold printed circuit boards;
- a panel (3) provided with two opposite sides (31, 32), wherein the first frame (1) is mounted on a first (31) of the two sides (31, 32) and the second frame (2) is mounted on a second (32) of the two sides (31, 32);
**characterized in that** the at least one deflecting means is further adapted to deflect at least another part of said airflow for cooling the printed circuit boards held by the second frame (2) of the other shelf.

17. Method for cooling printed circuit boards contained within a housing , said housing comprising at least a first zone wherein one or more printed circuit boards are located and a second zone wherein one or more printed circuit boards are located,
**characterized by** comprising the following steps:
- generating an airflow for cooling the printed circuit boards located in said first zone, and
- deflecting at least part of said airflow into said second zone for cooling the printed circuit boards located in said second zone.

18. Cooling method according to claim 17, wherein said airflow passes through said first zone before being at least partially deflected into said second zone.

19. Cooling method according to claim 18, wherein said airflow passes through said first zone before being at least partially diverted back into said second zone.

20. Cooling method according to claim 18 or 19, wherein said airflow enters said first zone (1) on one side and exits from said first zone (1) on the opposite side and wherein at least part of said airflow exiting from said first zone (1) enters said second zone (2) on one side corresponding to the opposite side of said first zone (1).

21. Cooling method according to any of claims from 18 to 20, wherein said airflow exiting from said first zone (1) is deflected before being at least partially intercepted and further deflected into said second zone (2).

22. Cooling method according to any of claims from 18 to 21, wherein said first zone (1) belongs to a first equipment of said housing and said second zone (2) belongs to a second equipment of said housing.
